# EUROPEAN PATENT APPLICATION

(11) **EP 4 228 155 A1**
(43) Date of publication of application: **16.08.2023**
(21) Application number: 20960206.9
(22) Date of filing: 03.11.2020
(51) Int. Cl.: H03H 9/02, H03H 9/125

(54) **RESONATOR, FILTER, AND ELECTRONIC DEVICE**

(71) Applicant: Huawei Technologies Co., Ltd., Shenzhen, Guangdong 518129 (CN)
(72) Inventor: XIAO, Xiang, Shenzhen, Guangdong 518129 (CN); KAZUNORI, Nishimura, Shenzhen, Guangdong 518129 (CN)
(74) Representative: MERH-IP Matias Erny Reichl Hoffmann Patentanwälte PartG mbB
(86) International application number: PCT/CN2020/126075
(87) International publication number: WO 2022/094743

(57) **Abstract**

A resonator, a filter (1010), and an electronic device (100), which relate to the field of harmonic suppression technologies and can reduce a spurious mode of the resonator between a resonance point and an anti-resonance point. The resonator includes a piezoelectric substrate (200) and an interdigital transducer (01), where the interdigital transducer (01) includes a plurality of first interdigital electrodes (11) and a plurality of second interdigital electrodes (12) that are alternately disposed in parallel in a first direction (XX'), a first bus bar (10) and a second bus bar (20) that are distributed on different sides of the plurality of interdigital electrodes (T) in a direction perpendicular to the first direction (YY'), the first bus bar (10) is connected to the first interdigital electrode (11), the second bus bar (20) is connected to the second interdigital electrode (12), a first piston (1) and a second piston (3) disposed on upper surfaces of two end portions of the first interdigital electrode (11), a third piston (3) and a fourth piston (4) disposed on upper surfaces of two end portions of the second interdigital electrode (12), where the first piston (1) is close to the first bus bar (10) relative to the second piston (2), the third piston (3) is close to the first bus bar (1) relative to the fourth piston (4), the first piston (1) and the third piston (3) have different lengths, and the second piston (2) and the fourth piston (4) have different lengths.

## Description

### TECHNICAL FIELD

This application relates to the field of harmonic suppression technologies, and in particular, to a resonator, a filter, and an electronic device.

### BACKGROUND

A filter is widely applied, especially an important component in a wireless communication device. In the filter, because a spurious mode (spurious mode) exists between a resonance point and an anti-resonance point in a resonator for establishing the filter, the spurious mode causes a large quantity of ripples (ripple) to appear in a passband of the filter in a propagation process, which affects response of the filter and performance of a circuit system established by the filter. Therefore, currently, a problem that needs to be urgently resolved in the filter is the large quantity of ripples (ripple) in the passband of the filter

### SUMMARY

Embodiments of this application provide a resonator, a filter, and an electronic device, to reduce a spurious mode of the resonator.

This application provides a resonator, including a piezoelectric substrate and an interdigital transducer disposed on the piezoelectric substrate, where the interdigital transducer includes a plurality of interdigital electrodes, a first bus bar, a second bus bar, a first piston suppression structure (a first piston), a second piston suppression structure (a second piston), a third piston suppression structure (a third piston), and a fourth piston suppression structure (a fourth piston). The plurality of interdigital electrodes include a first interdigital electrode and a second interdigital electrode that are alternately disposed in sequence and disposed in parallel, and a parallel disposition direction of the plurality of interdigital electrodes is a first direction. The first bus bar and the second bus bar are distributed on different sides of the plurality of interdigital electrodes in a direction perpendicular to the first direction, the first bus bar is connected to the first interdigital electrode, and the second bus bar is connected to the second interdigital electrode. The first piston and a second piston are respectively disposed on two end surfaces of a side of the first interdigital electrode away from the piezoelectric substrate, and a third piston and a fourth piston are respectively disposed on two end surfaces of a side of the second interdigital electrode away from the piezoelectric substrate, where the first piston is close to the first bus bar relative to the second piston, the third piston is close to the first bus bar relative to the fourth piston, the first piston and the third piston have different lengths, and the second piston and the fourth piston have different lengths.

According to the resonator provided in embodiments of this application, the first interdigital electrode and the second interdigital electrode that are alternately disposed in the interdigital transducer are located on end surfaces on a same side, and piston suppression structures (piston) of different lengths are alternately disposed, so that two low sound speed regions can be respectively formed at two ends of the first interdigital electrode and the second interdigital electrode that are close to the first bus bar and the second bus bar, and a transverse wave can be suppressed to form resonance between the first bus bar and the second bus bar, the spurious mode between the resonance point and the anti-resonance point of the resonator is reduced, and the ripples in the passband of the filter are reduced.

In some possible implementations, a length of the first piston is less than a length of the third piston, and a length of the fourth piston is less than a length of the second piston.

In some possible implementations, the length of the first piston is the same as the length of the fourth piston, and the length of the second piston is the same as the length of the third piston.

In some possible implementations, the first piston is flush with an edge of the third piston on a side close to the second bus bar, and the second piston is flush with an edge of the fourth piston on a side close to the first bus bar.

In some possible implementations, the interdigital transducer further includes a first dummy finger electrode (which may also be referred to as a first dummy or a first dummy finger) and a second dummy finger electrode (which may also be referred to as a second dummy or a second dummy finger). The first dummy finger electrode is disposed between the first bus bar and the second interdigital electrode, and the first dummy finger electrode is connected to the first bus bar, the second dummy finger electrode is disposed between the second bus bar and the first interdigital electrode, and the second dummy finger electrode is connected to the second bus bar. The dummy finger electrode (dummy) is disposed, so that a low sound speed region can be formed in a setting region of the dummy finger electrode, to further suppress a transverse wave of the interdigital electrode corresponding to the dummy finger electrode from leaking in a direction of the dummy finger electrode, improve the transverse wave suppression effect, and further reduce ripples in the passband of the filter, especially suppression effect that can be performed on transverse harmonic leakage close to the anti-resonance point.

In some possible implementations, the resonator further includes a reflective structure that is disposed on the piezoelectric substrate and that is respectively located on two sides of the interdigital transducer in the first direction, where the reflective structure includes a plurality of reflective electrodes disposed in parallel in the first direction, and a first reflective bus bar and a second reflective bus bar that are located on two sides of the plurality of reflective electrodes in the first direction, the first reflective bus bar and the first bus bar are located on a same side, and the second reflective bus bar and the second bus bar are located on a same side. In this case, a surface acoustic wave is reflected by the reflective structure on the two sides, so that the sound wave is restricted between the two reflective structures, and the quality factor (that is, a Q factor and a Q value) of the resonator is improved.

In some possible implementations, two ends of the plurality of reflective electrodes are respectively connected to the first reflective bus bar and the second reflective bus bar.

In some possible implementations, the plurality of reflective electrodes include a first reflective electrode and a second reflective electrode that are alternately disposed in sequence, and a boundary reflective electrode located on an outermost side in a direction away from the interdigital transducer, where the first reflective electrode is connected to the first reflective bus bar, the second reflective electrode is connected to the second reflective bus bar, and two ends of the boundary reflective electrode are respectively connected to the first reflective bus bar and the second reflective bus bar.

In some possible implementations, the reflective structure further includes a first dummy finger reflective electrode (which may also be referred to as a first reflective dummy or a first reflective dummy finger) and a second dummy finger reflective electrode (which may also be referred to as a second reflective dummy or a second reflective dummy finger). The first dummy finger reflective electrode is disposed between the first reflective bus bar and the second reflective electrode, and the first dummy finger reflective electrode is connected to the first reflective bus bar, the second dummy finger reflective electrode is disposed between the second reflective bus bar and the first reflective electrode, and the second dummy finger reflective electrode is connected to the second reflective bus bar.

In some possible implementations, the reflective structure further includes reflective piston suppression structures (that is, reflective pistons) disposed on two end surfaces of the reflective electrode on a side away from the piezoelectric substrate, a reflective piston located on a surface of the reflective electrode and close to a side of the first reflective bus bar is disposed in a same manner as the first piston and the third piston, and a reflective piston located on a surface of the reflective electrode and close to a side of the second reflective bus bar is disposed in a same manner as the second piston and the fourth piston, to further improve reflection of a sound wave by the reflective structure, restrict the sound wave between the two reflective structures, and improve a quality factor of the resonator.

In some possible implementations, the piezoelectric substrate includes a support layer, a charge trapping layer, a sound speed control layer, and a piezoelectric layer that are sequentially disposed in a direction close to the interdigital transducer.

In some possible implementations, the piezoelectric substrate includes a single-layer piezoelectric wafer substrate.

In some possible implementations, the resonator further includes an insulating dielectric layer covering a surface of a side of the interdigital transducer away from the piezoelectric substrate.

In some possible implementations, the resonator includes a plurality of interdigital transducers disposed in parallel in the first direction.

Embodiments of this application further provide a filter, including the resonator according to any one of the possible implementations.

Embodiments of this application further provide an electronic device, including a transceiver, a memory, and a processor. The transceiver includes the filter according to any one of the possible implementations.

### BRIEF DESCRIPTION OF DRAWINGS

FIG. 1 is a schematic diagram of a structure of an electronic device according to an embodiment of this application;
FIG. 2 is a schematic diagram of a structure of a resonator according to an embodiment of this application;
FIG. 3 is a schematic cross-sectional view of FIG. 1 along a position Al-A2-A3;
FIG. 4a is a schematic curve of distribution of a resonator and a sound speed of the resonator in a transverse direction (y) according to an embodiment of this application;
FIG. 4b is a schematic curve of distribution of a resonator and a sound speed of the resonator in a transverse direction (y) according to an embodiment of this application;
FIG. 5a is a schematic diagram of a structure of a resonator according to an embodiment of this application;
FIG. 5b is a schematic curve of distribution of a resonator and a sound speed of the resonator in a transverse direction (y) according to an embodiment of this application;
FIG. 6 is a schematic diagram of a structure of a resonator according to an embodiment of this application;
FIG. 7 is a schematic diagram of a structure of a resonator according to an embodiment of this application;
FIG. 8 is a schematic diagram of a reflective structure in a resonator according to an embodiment of this application;
FIG. 9 is a schematic diagram of a reflective structure in a resonator according to an embodiment of this application;
FIG. 10 is a schematic diagram of a structure of a resonator according to an embodiment of this application;
FIG. 11a is a schematic cross-sectional view of FIG. 1 along a position of A1-A2-A3;
FIG. 11b is a schematic cross-sectional view of FIG. 1 along a position of A1-A2-A3;
FIG. 11c is a schematic cross-sectional view of FIG. 1 along a position of A1-A2-A3;
FIG. 12 is a schematic diagram of a structure of a resonator according to an embodiment of this application;
FIG. 13 is a schematic diagram of a structure of a filter according to an embodiment of this application; and
FIG. 14 is a schematic diagram of a structure of a filter according to an embodiment of this application.

### DESCRIPTION OF EMBODIMENTS

To make the objectives, technical solutions, and advantages of this application clearer, the following clearly describes the technical solutions in this application with reference to the accompanying drawings in this application. It is clear that the described embodiments are merely a part rather than all of the embodiments of this application. All other embodiments obtained by a person of ordinary skill in the art based on embodiments of this application without creative efforts shall fall within the protection scope of this application.

In the specification, embodiments, claims, and accompanying drawings of this application, terms "first", "second", and the like are merely intended for distinguishing and description, and shall not be understood as an indication or implication of relative importance or an indication or implication of an order. "At least one" refers to one or more, and "a plurality of" refers to two or more. In addition, the terms "include", "have", and any variant thereof are intended to cover non-exclusive inclusion, for example, include a series of steps or units. Methods, systems, products, or devices are not necessarily limited to those steps or units that are literally listed, but may include other steps or units that are not literally listed or that are inherent to such processes, methods, products, or devices. "Up", "down", "left", "right", and the like are used only relative to the orientation of the components in the accompanying drawings. These directional terms are relative concepts, and are used for relative descriptions and clarifications, and may vary accordingly depending on position changes of components in the accompanying drawings.

Embodiments of this application provide an electronic device. A filter is disposed in the electronic device, and an interference signal is suppressed by the filter, to achieve a filtering function.

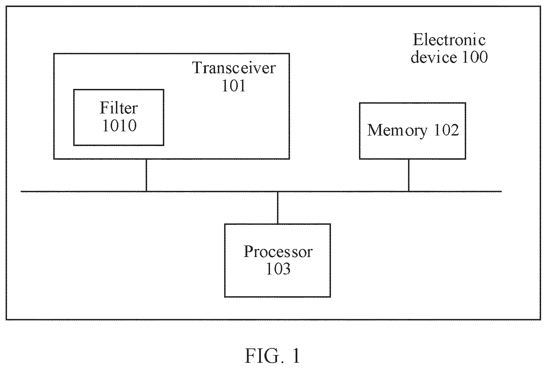

For example, in some possible implementations, as shown in FIG. 1, the electronic device 100 may include a transceiver 101, a memory 102, and a processor 103 (which may be a local processor or a cloud processor), where a filter 1010 is disposed in the transceiver 101, and the filter 1010 is constructed by using a resonator.

A specific form of the electronic device is not limited in this application. For example, the electronic device may be a television, a mobile phone, a satellite communication device, or a cable television.

In the resonator disposed in the filter used in the electronic device in this application, a piston suppression structure (piston) is disposed on a surface of the interdigital electrode, so that there is a small quantity of spurious modes between a resonance point and an anti-resonance point, thereby reducing ripples in a passband of the filter constructed by the resonator. For example, the resonator in this application may be a surface acoustic wave resonator (that is, a SAW resonator). The following embodiments are described by using this as an example.

The following further describes a specific disposing condition of the resonator provided in embodiments of this application.

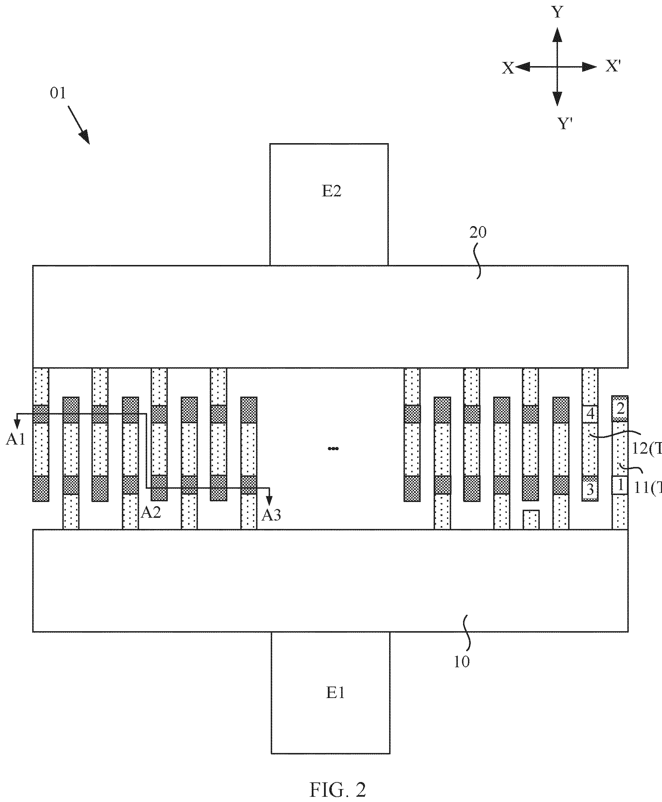

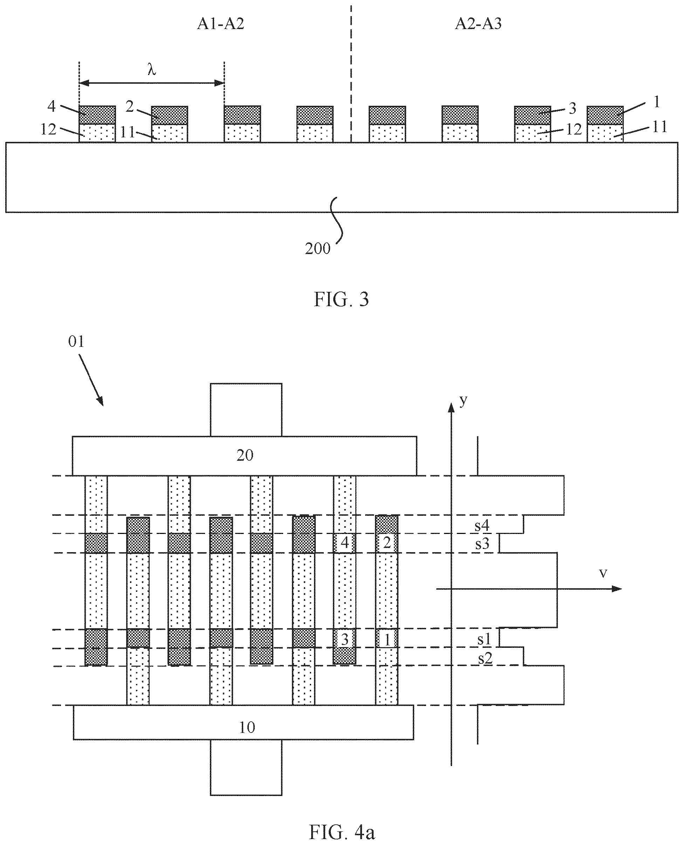

With reference to FIG. 2 and FIG. 3 (a schematic cross-sectional view of FIG. 2 along a position A1-A2-A3), the resonator includes a piezoelectric substrate 200 and an interdigital transducer 01 disposed on the piezoelectric substrate 200.

As shown in FIG. 2, the interdigital transducer 01 includes a plurality of interdigital electrodes T disposed in parallel in a first direction XX', where the plurality of interdigital electrodes include a first interdigital electrode 11 and a second interdigital electrode 12 that are alternately disposed in sequence, and a second bus bar (that is, a second bus bar) 20 and a first bus bar (that is, a first bus bar) 10 are respectively disposed on upper and lower sides of the plurality of interdigital electrodes T in a second direction YY' (that is, perpendicular to the first direction XX'), where lower end portions of all first interdigital electrodes 11 are connected to the first bus bar 10, and upper end portions of all second interdigital electrodes 12 are connected to the second bus bar 20.

It may be understood that, in the interdigital transducer 01, the first interdigital electrode 11 and the second interdigital electrode 12 are periodically, repeatedly, and alternately disposed. An arrangement period of the first interdigital electrode 11 and the second interdigital electrode 12 may be basically the same as a wavelength λ of a surface acoustic wave generated by the interdigital transducer 01, that is, a distance between two adjacent interdigital electrodes connected to a same bus bar is equal to the wavelength λ (refer to FIG. 3). λ in the following refers to a wavelength of a surface acoustic wave generated by the interdigital transducer 01. Details are not described in the following.

Refer to FIG. 2 and FIG. 3, a first piston suppression structure (that is, a first piston) 1 and a second piston suppression structure (that is, a second piston) 2 are respectively disposed on upper surfaces (that is, a surface away from the piezoelectric substrate 200) of two ends of the first interdigital electrode 11, and a third piston suppression structure (that is, a third piston) 3 and a fourth piston suppression structure (that is, a fourth piston) 4 are respectively disposed on upper surfaces (that is, a surface away from the piezoelectric substrate 200) of two ends of the second interdigital electrode 12. The first piston 1 is close to the first bus bar 10 relative to the second piston 2, and the third piston 3 is close to the first bus bar 10 relative to the fourth piston 4. That is, the first piston 1 and the third piston 3 are located on a same side end of the interdigital electrode, and the second piston 2 and the fourth piston 4 are located on a same side end of the interdigital electrode.

It should be noted that, FIG. 2 is merely an example in which a first piston 1 and a second piston 2 are disposed on an upper surface of each first interdigital electrode 11, and a third piston 3 and a fourth piston 4 are disposed on an upper surface of each second interdigital electrode 12. However, this application is not limited thereto. In some possible implementations, the first piston 1 and the second piston 2 may be disposed only on an upper surface of a part of the interdigital electrode 11, and the third piston 3 and the fourth piston 4 may be disposed on an upper surface of a part of the second interdigital electrode 12.

In addition, as shown in FIG. 2, in the interdigital transducer 01, the first piston 1 and the third piston 3 have different lengths, and the second piston 2 and the fourth piston 4 have different lengths.

For example, in some possible implementations, as shown in FIG. 4a, it may be set that a length of the first piston 1 is less than a length of the third piston 3, and a length of the fourth piston 4 is less than a length of the second piston 2.

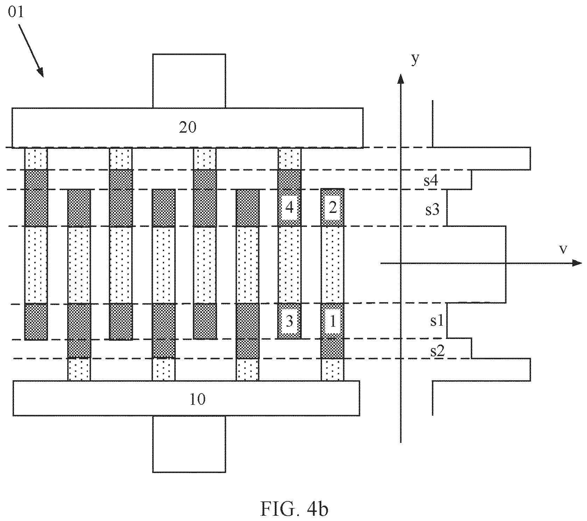

For example, in some possible implementations, as shown in FIG. 4b, it may be set that a length of the first piston 1 is greater than a length of the third piston 3, and a length of the fourth piston 4 is greater than a length of the second piston 2.

Refer to FIG. 4a and FIG. 4b. The pistons (1, 2, 3, 4) are disposed, so that the resonator can generate a relatively small sound speed (v) at a position (y) at which the piston is disposed on the interdigital electrodes (1, 2), to form a low sound speed region. In this case, the first piston 1 and the third piston 3 are disposed to have different lengths, two different low sound speed regions (s1, s2) can be formed in a region in which the pistons (1, 3) are disposed on a side of the interdigital electrodes (1, 2) close to the first bus bar 10. Similarly, the second piston 2 and the fourth piston 4 are disposed to have different lengths, two different low sound speed regions (s3, s4) can be formed in a region in which the pistons (2, 4) are disposed on a side of the interdigital electrodes (1, 2) close to the second bus bar 20. In this case, the low sound speed region is formed on two sides in a direction perpendicular to the wave propagation (that is, a transverse direction), so that resonance formed by reflection of the transverse wave between the first bus bar 10 and the second bus bar 20 can be suppressed (that is, a transverse mode wave is suppressed), and the spurious mode of the resonator between the resonance point and the anti-resonance point are reduced, thereby reducing ripples in the passband of the filter.

In the following embodiments, as shown in FIG. 4a, an example in which a length of the first piston 1 is less than a length of the third piston 3 and a length of the fourth piston 4 is less than a length of the second piston 2 is used to further describe this application.

As shown in FIG. 2, in the interdigital transducer 01, a first electrode E1 connected to the first bus bar 10 and a second electrode E2 connected to the second bus bar 20 may be further disposed. The first electrode E1 applies an electrical signal to the first interdigital electrode 11 through the first bus bar 10, and the second electrode E2 applies the electrical signal to the second interdigital electrode 12 through the second bus bar 20, to implement conversion between acoustic signals and electrical signals.

To simplify a process and reduce manufacturing costs, in some possible implementations, refer to FIG. 2 and FIG. 3, the first interdigital electrode 11 and the second interdigital electrode 12 may be obtained by using a same metal thin film through patterning. In other words, the first interdigital electrode 11 and the second interdigital electrode 12 are disposed on a same layer and made of a same material.

For example, the first interdigital electrode 11 and the second interdigital electrode 12 may use one or more of materials such as aluminum (Al), an Al-based material (for example, AlCu and AlMg), copper (Cu), a Cu-based material, chromium (Cr), silver (Ag), gold (Au), platinum (Pt), or titanium (Ti), and a thickness of the first interdigital electrode 11 and a thickness of the second interdigital electrode 12 may be in a range of 0.01λ, to 0.2λ. The metal thin film forming the first interdigital electrode 11 and the second interdigital electrode 12 may be a single-layer metal thin film made of one material, or may be a composite metal thin film made of two or more materials. This is not limited in this application, and may be set according to a requirement in practice.

Herein, it should be noted that, for the first interdigital electrode 11 and the second interdigital electrode 12 that are obtained by using a same metal thin film through patterning, "patterning" herein may refer to a process including metal film layer deposition, photoresist coating, exposure, development, etching, and stripping (which may also be referred to as an etching process for short), to implement preparation of a pattern layer including the first interdigital electrode 11 and the second interdigital electrode 12, alternatively, "patterning" may refer to a process may include a process including photoresist coating, exposure, development, metal film layer deposition, and stripping (which may also be referred to as a stripping process for short), to implement preparation of a pattern layer including the first interdigital electrode 11 and the second interdigital electrode 12, which are not limited in this application. A proper patterning manufacturing process may be selected according to an actual requirement. This is the same as "patterning" in the following, and details are not described again.

In some possible implementations, refer to FIG. 2 and FIG. 3, the first piston 1, the second piston 2, the third piston 3, and the fourth piston 4 may be obtained by using a same thin film through patterning. In other words, the first piston 1, the second piston 2, the third piston 3, and the fourth piston 4 are disposed on a same layer and made of a same material.

For example, the first piston 1, the second piston 2, the third piston 3, and the fourth piston 4 may be made of a metal material, or may be made of a non-metal material. For example, the metal material may be made of one of aluminum (Al), an Al-based material (for example, AlCu and AlMg), copper (Cu), a Cu-based material, chromium (Cr), silver (Ag), gold (Au), platinum (Pt), or titanium (Ti). The non-metal material may be one or more of silicon dioxide (SiO₂), silicon nitride (SiₓN_{y}), aluminum oxide (AlₓO_{y}), tantalum oxide (Ta₂O₅), or pyridine oxide (HfₓO_{y}).

In addition, a thin film forming the first piston 1, the second piston 2, the third piston 3, and the fourth piston 4 may be a single-layer thin film formed by using one material, or may be a composite thin film formed by using two or more materials. This is not limited in this application, and may be set according to a requirement in practice.

For the first bus bar 10, the second bus bar 20, the first electrode E1, and the second electrode E2, in some possible implementations, the first bus bar 10, the second bus bar 20, the first electrode E1, and the second electrode E2 may be obtained by patterning a same metal thin film as the first interdigital electrode 11 and the second interdigital electrode 12. In other words, the first interdigital electrode 11, the second interdigital electrode 12, the first bus bar 10, the second bus bar 20, the first electrode E1, and the second electrode E2 are disposed on the same layer and made of the same material.

In some possible implementations, to increase thicknesses of the first bus bar 10, the second bus bar 20, the first electrode E1, and the second electrode E2, the first bus bar 10, the second bus bar 20, the first electrode E1, and the second electrode E2 may use a structure of two or more metal layers (that is, obtained by patterning a plurality of metal thin film layers). For example, the first bus bar 10, the second bus bar 20, the first electrode E1, and the second electrode E2 may be made of an upper and lower two-layer metal structure. The lower layer metal structure is obtained by using a same metal film as the first interdigital electrode 11 and the second interdigital electrode 12 by patterning, and the upper layer metal structure is obtained by using a same metal thin film as the first piston 1, the second piston 2, the third piston 3, and the fourth piston 4 by patterning.

In conclusion, in the resonator provided in embodiments of this application, the first interdigital electrode and the second interdigital electrode that are alternately disposed in the interdigital transducer are located on end surfaces on a same side, and pistons of different lengths are alternately disposed, so that two low sound speed regions can be respectively formed at two ends of the first interdigital electrode and the second interdigital electrode that are close to the first bus bar and the second bus bar, and resonance formed by reflection of the transverse wave between the first bus bar and the second bus bar can be suppressed, the clutter between the resonance point and the anti-resonance point of the resonator is reduced, and the ripples in the passband of the filter are reduced.

In some possible implementations, refer to FIG. 2, it may be set that a length of the first piston 1 is the same as a length of the fourth piston 4, and a length of the second piston 2 is the same as a length of the third piston 3, to improve a transverse wave suppression effect. Herein, it may be understood that the lengths of the pistons (1, 2, 3, 4) refer to sizes of the pistons in a second direction YY'.

For example, a length of the first piston 1 and a length of the fourth piston 4 may be in a range of 0.1λ to 1λ, and a length of the second piston 2 and a length of the third piston 3 may be in a range of 0.1λ to 1λ.

In practice, a setting parameter, for example, a length, a material, and a thickness, of each piston may be adjusted, to achieve an objective of optimizing a harmonic suppression effect.

For example, in some possible implementations, a thickness tₚᵢₛₜₒₙ of the piston (for example, 1, 2, 3, or 4) may be set to 10% to 30% of a thickness t_{IDT} of the interdigital electrode (1, 2). In other words, tₚᵢₛₜₒₙ=10%^{∗}t_{IDT} to 30%^{∗}t_{IDT}.

For example, in some possible implementations, as shown in FIG. 2, it may be set that the first piston 1 is flush with an edge of the third piston 3 on a side close to the second bus bar 20, and the second piston 2 is flush with an edge of the fourth piston 4 on a side close to the first bus bar 10.

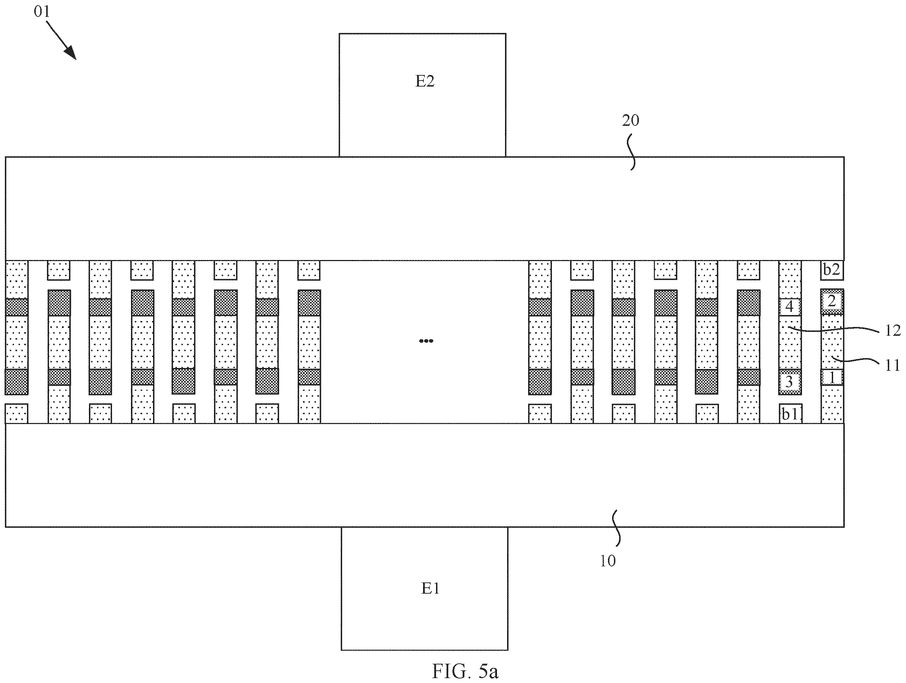

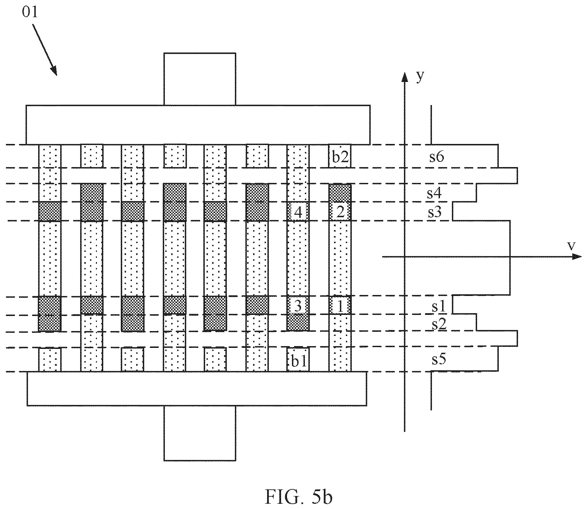

On this basis, in some possible implementations, as shown in FIG. 5a, the resonator may include a first dummy finger electrode b1 (which may also be referred to as a first dummy or a first dummy finger). The first dummy finger electrode b1 is disposed in a gap (gap) region between the second interdigital electrode 12 and the first bus bar 10 and at a position opposite to the second interdigital electrode 12, and the first dummy finger electrode b1 is connected to the first bus bar 10. In this case, refer to FIG. 5b, the resonator can further form a low sound speed region (s5) in a setting region of the first dummy finger electrode b1, to further suppress a transverse wave leakage in a direction towards the first bus bar 10, and improve the suppression of the transverse wave.

Similarly, the resonator may also be a second dummy finger electrode b2 (which may also be referred to as a second dummy or a second dummy finger). The second dummy finger electrode b2 is disposed in a gap (gap) region between the first interdigital electrode 11 and the second bus bar 20 and at a position opposite to the first interdigital electrode 11, and the second dummy finger electrode b2 is connected to the second bus bar 20. In this case, refer to FIG. 5b, the resonator can further form a low sound speed region (s6) in a setting region of the second dummy finger electrode b2, to further suppress the transverse wave leakage in a direction towards the second bus bar 20, and improve the suppression of the transverse wave.

Refer to FIG. 5b, the first dummy finger electrode b1 and the second dummy finger electrode b2 are disposed, so that the resonator forms low sound speed regions (s5, s6) in a setting region of the first dummy finger electrode b1 and the second dummy finger electrode b2, to further suppress leakage of a transverse wave in the direction of the first bus bar 10 and the second bus bar 20, thereby improving suppression of the transverse wave and reducing ripples in the passband of the filter. In particular, the suppression effect of the transverse harmonic leakage close to the anti-resonance point is especially obvious.

Based on this, to simplify a process and reduce manufacturing costs, in some possible implementations, refer to FIG. 5a, the first dummy finger electrode b1 and the second dummy finger electrode b2 may be disposed to be obtained by using a same metal thin film as the first interdigital electrode 11 and the second interdigital electrode 12 through patterning. In other words, the first interdigital electrode 11, the second interdigital electrode 12, the first dummy finger electrode b1, and the second dummy finger electrode b2 are disposed on the same layer and made of the same material.

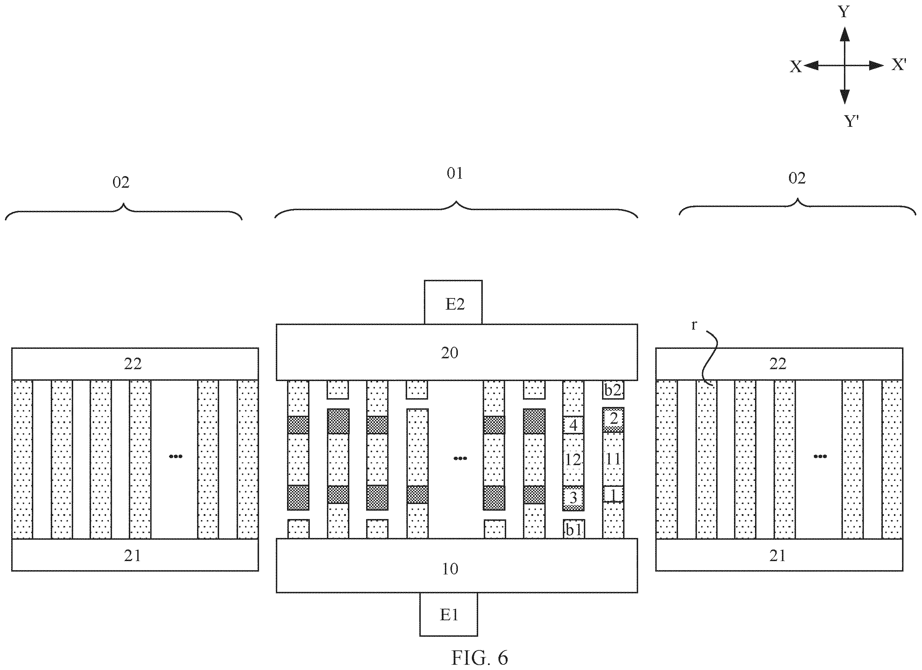

In addition, to improve the performance of the resonator, in some possible implementations, as shown in FIG. 6, the surface acoustic wave resonator may further include a reflective structure 02 that is disposed on the piezoelectric substrate 200 and that is respectively located on two sides of the interdigital transducer 01 in the first direction XX', to reflect a surface acoustic wave through the reflective structure 02 on the two sides, so that the surface acoustic wave is restricted between the two reflective structures 02, thereby improving a quality factor (that is, a Q factor and a Q value) of the surface acoustic wave resonator.

In some possible implementations, as shown in FIG. 6, FIG. 7, and FIG. 8, the reflective structure 02 may include a plurality of reflective electrodes r disposed in parallel with the interdigital electrodes (11, 12) in the first direction XX', and a first reflective bus bar 21 and a second reflective bus bar 22 that are located at two ends of the reflective electrode r in the second direction YY', where the first reflective bus bar 21 and the first bus bar 10 are located on a same side, and the second reflective bus bar 22 and the second bus bar 20 are located on a same side.

In the reflective structure 02, a manner of disposing the reflective electrode r and a manner of connecting the reflective electrode r to the reflective bus bars (21, 22) may be specifically set according to a requirement. The following provides the reflective structure 02 with three different structures.

### Disposing Manner 1

In some possible implementations, as shown in FIG. 6, in the reflective structure 02, a plurality of reflective electrodes r are disposed in parallel in the first direction XX', and two ends of the plurality of reflective electrodes r in the second direction YY' are respectively connected to the first reflective bus bar 21 and the second reflective bus bar 22.

### Disposing Manner 2

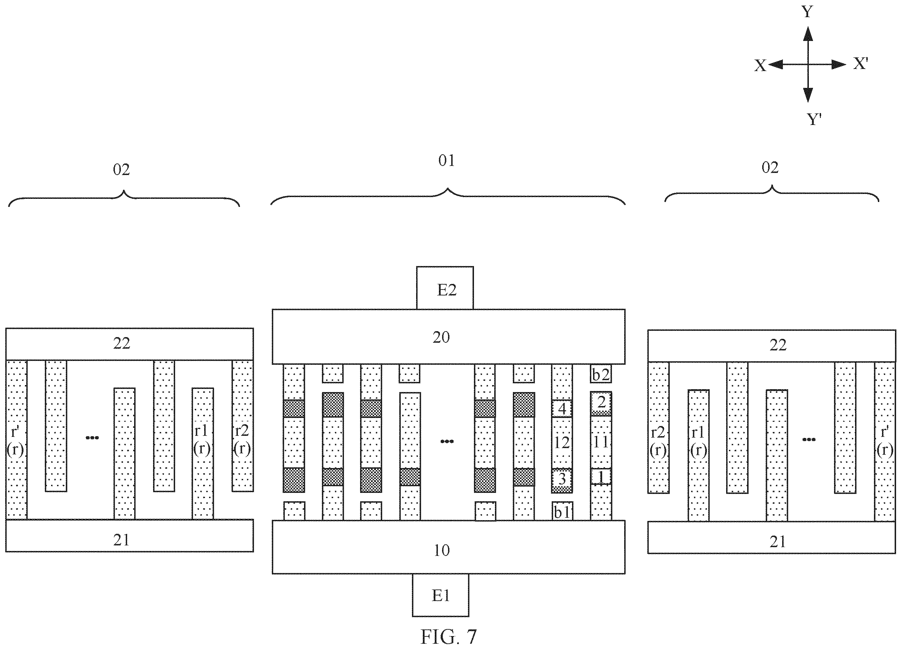

In some possible implementations, as shown in FIG. 7, in the reflective structure 02, the plurality of reflective electrodes r disposed in parallel in the first direction XX' include a first reflective electrode r1 and a second reflective electrode r2 that are alternately disposed in sequence, and a boundary reflective electrode r' located on an outermost side in a direction away from the interdigital transducer 01. The first reflective electrode r1 is connected to the first reflective bus bar 21, the second reflective electrode r2 is connected to the second reflective bus bar 22, and two ends of the boundary reflective electrode r' are respectively connected to the first reflective bus bar 21 and the second reflective bus bar 22. In this case, in the first direction XX', the disposing of the first reflective electrode r1 and the second reflective electrode r2 is equivalent to continuing a manner of disposing the first interdigital electrode 11 and the second interdigital electrode 12.

### Disposing Manner 3

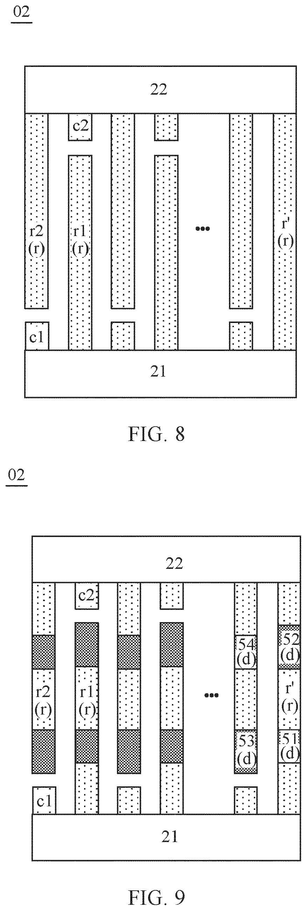

In some possible implementations, as shown in FIG. 8, based on the disposing manner 2, the reflective structure 02 further includes a first dummy finger reflective electrode c1 and a second dummy finger reflective electrode c2. The first dummy finger reflective electrode c1 is disposed in a gap region between the second reflective electrode r2 and the first reflective bus bar 21 and at a position opposite to the second reflective electrode r2, and the first dummy finger reflective electrode c1 is connected to the first reflective bus bar 21. The second dummy finger reflective electrode c2 is disposed at a gap between the first reflective electrode r1 and the second reflection bus bar 22, and at a position opposite to the first reflective electrode r1, and the second dummy finger reflective electrode c2 is connected to the second reflective bus bar 22. In this case, in the first direction XX', the first dummy finger reflective electrode c1 continues to be disposed in a manner of the first dummy finger electrode b1, and the second dummy finger reflective electrode c2 continues to be disposed in a manner of the second dummy finger electrode b2.

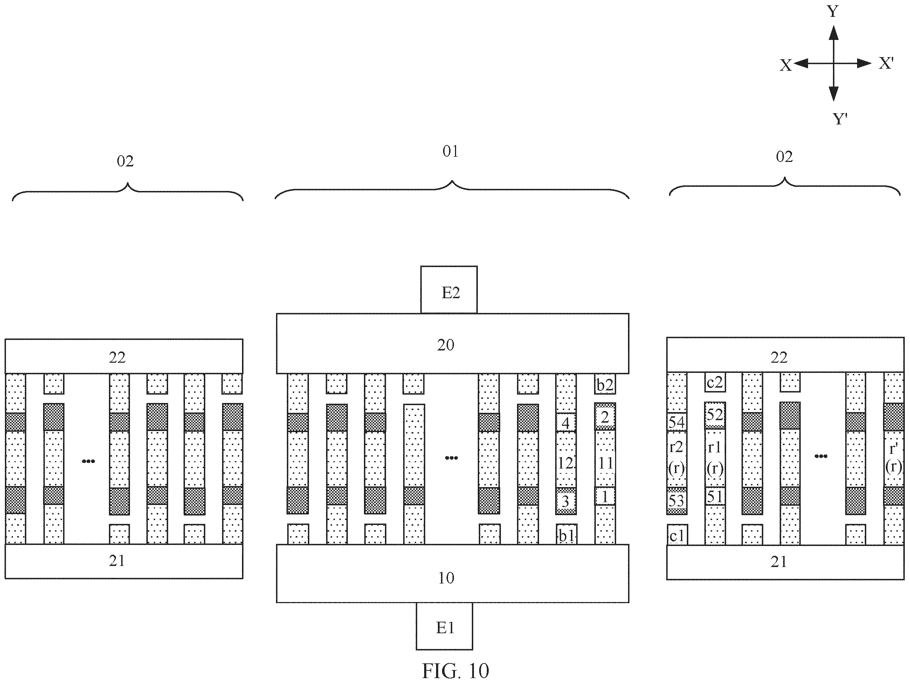

On this basis, to further improve reflection of a surface acoustic wave by the reflective structure, the surface acoustic wave is restricted between the two reflective structures, to improve a quality factor of a surface acoustic wave resonator. In some possible implementations, with reference to FIG. 9 and FIG. 10, in the reflective structure 02, a reflective piston d may be respectively disposed on upper surfaces (that is, surfaces on a side away from the piezoelectric substrate 200) of two ends of the reflective electrode r.

Refer to FIG. 9, two adjacent reflective pistons of the reflective electrode r on a side close to the first reflective bus bar 21 are respectively a first reflective piston 51 and a third reflective piston 53, and the reflective pistons on a side close to the second reflective bus bar 22 are respectively a second reflective piston 52 and a fourth reflective piston 54. The first reflective piston 51 and the second reflective piston 52 are located on upper surfaces of two ends of a same reflective electrode r, and the third reflective piston 53 and the fourth reflective piston 54 are located on upper surfaces of two ends of the same reflective electrode r.

Refer to FIG. 10, a reflective piston (a first reflective piston 51 and a third reflective piston 53) located on a side of the reflective electrode r close to the first reflective bus bar 21 is disposed in a same manner as the first piston 1 and the third piston 3. In other words, the first reflective piston 51 and the first piston 1 are disposed in the same manner (which may include the shape, the size, a position in the second direction YY'), and the third reflective piston 53 and the third piston 3 are disposed in the same manner (which may include the shape, the size, a position in the second direction YY'). In this case, in a direction away from the interdigital transducer 01 (that is, the first direction XX'), it is equivalent to that the first reflective piston 51 and the third reflective piston 53 continue the disposing manners of the third reflective piston 53 and the third piston 3. Therefore, the reflection of the surface acoustic wave by the reflective structure is improved.

Similarly, refer to FIG. 10, a reflective piston (a second reflective piston 52 and a fourth reflective piston 54) located on a side of the reflective electrode r close to the second reflective bus bar 22 is disposed in the same manner as the second reflective piston 2 and the fourth reflective piston 4. In other words, the second reflective piston 52 and the second reflective piston 2 are disposed in the same manner (which may include the shape, the size, a position in the second direction YY'), and the fourth reflective piston 54 and the fourth piston 4 are disposed in the same manner (which may include the shape, the size, a position in the second direction YY'). In this case, in the direction away from the interdigital transducer 01 (that is, the first direction XX'), it is equivalent to that the second reflective piston 52 and the fourth reflective piston 54 continue the disposing manners of the second piston 2 and the fourth piston 4. Therefore, the reflection of the surface acoustic wave by the reflective structure is improved.

It should be noted that, FIG. 10 is merely an example of the reflective structure 02 shown in the disposing manner 3, but this application is not limited thereto. The reflective structure 02 in the disposing manner 1 and disposing manner 2 may also be set according to the disposing manner of the reflective piston d shown in FIG. 10. Details are not described herein again.

To simplify a manufacturing process and reduce manufacturing costs, in some possible implementations, the reflective electrode r, the first reflective bus bar 21, the second reflective bus bar 22, the first dummy finger reflective electrode c1, and the second dummy finger reflective electrode c2 in the foregoing reflective structure 02 may be obtained by using a same metal thin film as the first interdigital electrode 11 and the second interdigital electrode 12 by patterning. In other words, the first interdigital electrode 11, the second interdigital electrode 12, the reflective electrode r, the first reflective bus bar 21, the second reflective bus bar 22, the first dummy finger reflective electrode c1, and the second dummy finger reflective electrode c2 are disposed on the same layer and made of the same material.

In some possible implementations, the reflective piston d in the foregoing reflective structure 02 may be obtained by using a same thin film as the first piston 1, the second piston 2, the third piston 3, and the fourth piston 4 by patterning. In other words, the first piston 1, the second piston 2, the third piston 3, the fourth piston 4, and the reflective piston d are disposed on the same layer and made of the same material.

In addition, for the piezoelectric substrate 200 in the resonator:

In some possible implementations, refer to FIG. 3, the piezoelectric substrate 200 may be a single-layer piezoelectric wafer substrate, in other words, the single-layer piezoelectric wafer serves as both a piezoelectric layer and a support substrate.

For example, the single-layer piezoelectric wafer substrate may be at least one of lithium niobate (LiNbO3) or lithium tantalite (LiTaO₃), and a thickness of the single-layer piezoelectric wafer substrate may be in a range of 10 µm to 1 mm.

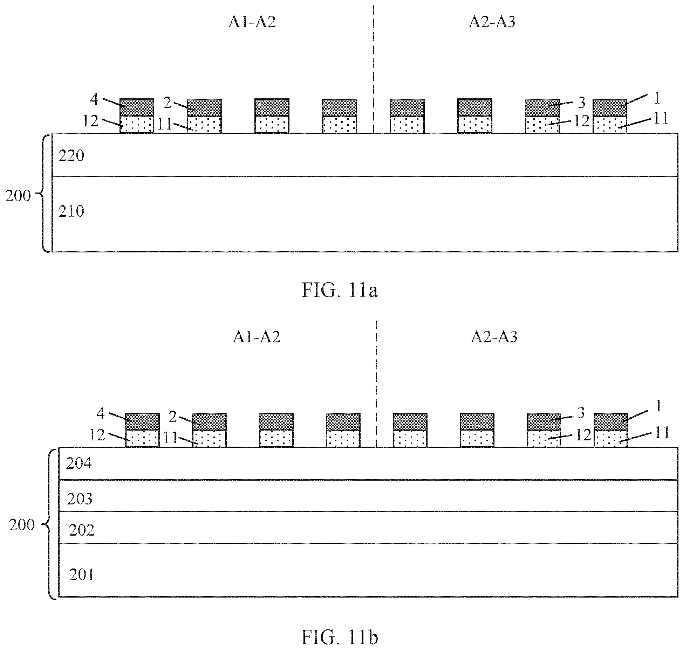

In some possible implementations, refer to FIG. 11a (another disposing manner of the piezoelectric substrate 200 in FIG. 2), the piezoelectric substrate 200 may be a bonded piezoelectric wafer substrate. For example, the piezoelectric layer 220 may be bonded on a Si semiconductor layer 210, and the interdigital transducer 01 is disposed on an upper surface of the piezoelectric layer 220. The piezoelectric layer 120 may be one of LiTaO3 or LiNbO3, and a thickness of the piezoelectric layer may be in a range of 1 µm to 200 µm.

In some possible implementations, refer to FIG. 11b (another disposing manner of the piezoelectric substrate 200 in FIG. 2), the piezoelectric substrate 200 may include a support layer 201, a charge trapping layer 202, a sound speed control layer 203, and a piezoelectric layer 204 that are sequentially disposed in a direction close to the interdigital transducer 01.

For the foregoing support layer 201, the support layer 201 may be a rigid substrate formed by using one or more of materials such as silicon (Si), silicon carbide (SiC), sapphire (sapphire), quartz (quartz), spinel (spinel), glass (glass), or aluminum oxide (alumina), or may be a flexible substrate formed by using one or more of materials such as PET (polyethylene terephthalate, polyethylene terephthalate), PEN (polyethylene naphthalate, polyethylene naphthalate), PI (polyimide, polyimide), or PES (polyether sulphone, polyether sulphone).

For example, in some embodiments, the foregoing support layer 201 may be silicon (Si), and a thickness of the support layer 201 may be in a range of 10 µm to 1 mm.

The foregoing charge trapping layer 202 may be made of a material that can perform charge fixing, to reduce radio frequency leakage of the resonator.

For example, in some embodiments, the charge trapping layer 202 may use a special form of silicon (Si)-based material, for example, amorphous Si or nanocrystalline Si, and a thickness of the charge trapping layer 202 may be in a range of 100 nm to 10 µm.

The foregoing sound speed control layer 203 may be a single-layer low sound speed control layer, or may be a two-layer or multi-layer structure in which a high sound speed control layer and a low sound speed control layer are alternately combined. A material for forming the sound speed control layer 203 may include one or more of materials such as silicon dioxide (SiO₂), silicon nitride (SiₓN_{y}), aluminum nitride (AlN), scandium aluminum nitride (ScAlN), tantalum oxide (Ta₂O₅), tantalum (Ta), pyridine oxide (HfₓO_{y}), tungsten (W), platinum (Pt), or bait (Ir). The sound speed control layer 203 may be a single-layer structure formed by using one material, or may be a composite layer formed by using two or more materials.

For example, in some embodiments, the sound speed control layer 203 may use silicon dioxide (SiO₂), and a thickness of the sound speed control layer 203 may be in a range of 10 nm to 10 µm.

The foregoing piezoelectric layer 204 may be made of a material such as lithium niobate (LiNbO3), lithium tantalumate (LiTaO₃), quartz (quartz), aluminum nitride (AlN), scandium aluminum nitride (ScAlN), PZT (lead zirconate titanate, lead zirconate titanate) piezoelectric ceramic, zinc oxide (ZnO), or a PMN-PT-based material (that is, a PMN-PT - lead titanate piezoelectric material), and the piezoelectric layer 204 may be a single-layer structure formed by using one material, or may be a composite layer formed by using two or more materials.

For example, in some embodiments, the piezoelectric layer 204 may be a lithium tantalumate (LiTaO₃), and a thickness of the piezoelectric layer 204 may be in a range of 100 nm to 700 µm.

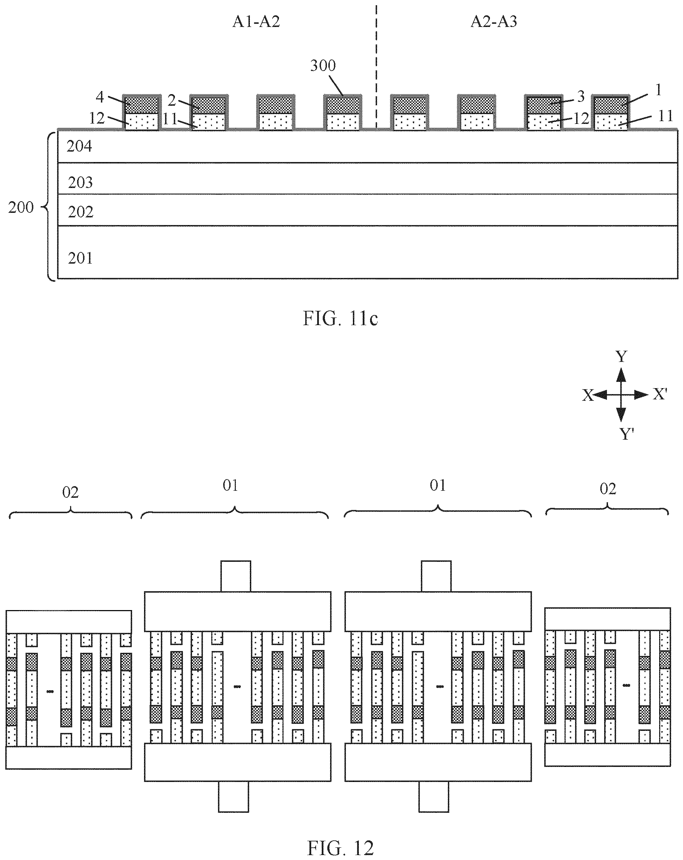

In some possible implementations, refer to FIG. 2 and FIG. 11c, according to an actual application scenario of the resonator, in the resonator, an insulating dielectric layer 300 covering a side of the interdigital transducer 01 away from the piezoelectric substrate 200 may be further disposed, to protect a surface of the interdigital transducer 01 through the insulating dielectric layer 300.

Certainly, in a case that the resonator includes the reflective structure 02, the insulating dielectric layer 300 extends to a surface of the reflective structure 02, to protect the reflective structure 02.

The insulating dielectric layer 300 may be made of one or more of materials such as silicon dioxide (SiO₂), silicon nitride (SiₓN_{y}), aluminum oxide (AlₓO_{y}), tantalum oxide (Ta₂O₅), or pyridium oxide (HfₓO_{y}), and the insulating dielectric layer 300 may be a single-layer structure formed by using one material, or may be a composite layer formed by using two or more materials.

For example, in some embodiments, the insulating dielectric layer 300 may be a composite layer formed by using a silicon oxide (SiO₂) layer and silicon nitride (SiₓN_{y}) layer. A thickness of the SiO₂ layer located at a lower layer is in a range of 5 nm to 50 nm, and a thickness of the SiₓN_{y} layer located at an upper layer is in a range of 5 nm to 20 nm.

In addition, the SAW resonator provided in embodiments of this application may be a dual mode surface acoustic wave resonator, that is, a DMS resonator (dual mode SAW), or may be referred to as a DMS for short. As shown in FIG. 12, the DMS resonator may include a plurality of interdigital transducers 01 disposed in parallel in a first direction XX', and FIG. 12 is merely an example in which two interdigital transducers 01 are disposed in parallel in a dual mode surface acoustic wave resonator is used for description. In some possible implementations, more than two interdigital transducers 01 (for example, 4, 5, and 6) may be disposed in parallel, a quantity of interdigital transducers 01 disposed in parallel in the DMS resonator is not limited in this application. In practice, the interdigital transducers 01 may be selectively disposed according to a requirement.

In some possible implementations, as shown in FIG. 12, the DMS resonator may further include a reflective structure 02 respectively located on an outer side of the plurality of interdigital transducers 01 that are disposed in parallel in the first direction XX', to increase a Q factor of the dual mode surface acoustic wave resonator.

The following uses a resonator shown in FIG. 10 as an example to describe a method for manufacturing the resonator provided in embodiments of this application.

Step 01. Set a piezoelectric substrate 200.

For example, in some possible implementations, as shown in FIG. 11b, the piezoelectric substrate 200 may include a support layer 201, a charge trapping layer 202, a sound speed control layer 203, and a piezoelectric layer 204 that are sequentially disposed from bottom to top, where the support layer 101 may be a silicon (Si) layer with a thickness of 200 µm to 700 µm, the charge trapping layer 102 is an amorphous Si layer with a thickness of 100 nm to 10 µm, the sound speed control layer 103 may be a silicon dioxide (SiO₂) layer with a thickness of 300 nm to 2 µm, and the piezoelectric layer 104 may be a lithium tantalite (LiTaO₃) layer with a thickness of 200 nm to 1 µm.

For other disposing conditions of the piezoelectric substrate 200, refer to the foregoing embodiments, and details are not described herein again.

Step 02. Form a first metal thin film on a surface of the piezoelectric substrate 200, and pattern the first metal thin film to form a first metal pattern. The first metal pattern includes a first interdigital electrode 11, a second interdigital electrode 12, a first dummy finger electrode b1, a second dummy finger electrode b2, a first bus bar 10, a second bus bar 20, a first electrode E1, and a second electrode E2 formed in an interdigital transducer 01, and a first reflective bus bar 21, a second reflective bus bar 22, a reflective electrode r, a first dummy finger reflective electrode c1, and a second dummy finger reflective electrode c2 in a reflective structure 02.

For specific relative positions and connection relationships of components in the interdigital transducer 01 and the reflective structure 02, reference may be made to the foregoing embodiments. Details are not described herein again.

For example, the first metal thin film may be a Ti/AlCu composite film layer, where a content of Cu is in a range of 0.5% to 2%, a thickness of a Ti layer located at a lower layer may be in a range of 5 nm to 30 nm (for example, may be 20 nm), and a thickness of an AlCu located at an upper layer may be in a range of 0.05λ to 0.12λ.

Step 03. Form a second metal thin film on the first metal pattern (including 1, 2, b1, b2, 10, 20, E1, E2, 21, 22, r, c1, and c2) formed after the first metal thin film is patterned, and pattern the second metal thin film to form a second metal pattern, where the second metal pattern includes a first piston 1, a second piston 2, a third piston 3, a fourth piston 4, and a reflective piston d.

Certainly, to increase thicknesses of the first bus bar 10, the second bus bar 20, the first electrode E1, and the second electrode E2, in some possible implementations, in step 03, when the second metal thin film is patterned, thickening electrodes of the first bus bar 10, the second bus bar 20, the first electrode E1, and the second electrode E2 may be formed at positions corresponding to the first bus bar 10, the second bus bar 20, the first electrode E1, and the second electrode E2.

For example, the second metal thin film may be a Ti/AlCu composite film layer, where a content of Cu is in a range of 0.5% to 2%, a thickness of a Ti layer located at a lower layer may be in a range of 5 nm to 30 nm (for example, may be 20 nm), and a thickness of an AlCu located at an upper layer may be in a range of 0.5 µm to 3 µm.

In some possible implementations, to further increase thicknesses of the first bus bar 10, the second bus bar 20, the first electrode E1, and the second electrode E2, after step 03, a third metal thin film may be formed on the second metal pattern (including 10, 20, E1, and E2) through step 04, and the third metal thin film is patterned to form thickening electrodes of the first bus bar 10, the second bus bar 20, the first electrode E1, and the second electrode E2.

For example, the third metal thin film may be a Ti/Au composite film layer, a thickness of a Ti layer located at a lower layer may be in a range of 5 nm to 30 nm (for example, may be 20 nm), and a thickness of Au located at an upper layer may be in a range of 0.5 µm to 3 µm.

Herein, it may be understood that, the first bus bar 10, the second bus bar 20, the first electrode E1, and the second electrode E2 may use a multi-composite layer structure (Ti/AlCu/Ti/AlCu) formed by the first metal thin film (for example, Ti/AlCu) and the second metal thin film (for example, Ti/AlCu), or may use a multi-composite layer structure (Ti/AlCu/Ti/AlCu/Ti/Au) formed by the first metal thin film (for example, Ti/AlCu), the second metal thin film (for example, Ti/AlCu), and the third metal thin film (for example, Ti/Au).

In some possible implementations, as shown in FIG. 11c, after step 03 (or step 04), the method may further include forming an insulating dielectric layer 300 on the second metal pattern formed after the second metal thin film is patterned.

For example, the insulating dielectric layer 300 may include a SiO₂ layer located at a lower layer and having a thickness of 5 nm to 50 nm, and a SiₓN_{y} layer located at an upper layer and having a thickness of 5 nm to 20 nm.

In addition, a type of the filter constructed by the resonator provided in any one of the foregoing possible implementations is not limited in this application. For example, the filter may be a filter of a ladder (ladder) structure.

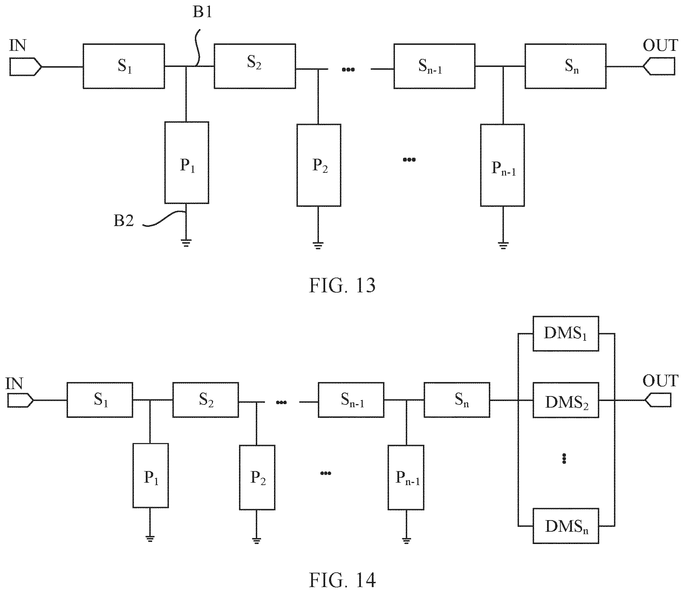

For example, in some possible implementations, the foregoing SAW resonator may be used to form a ladder filter. As shown in FIG. 13, the filter may include an input end IN, an output end OUT, a series branch B1, and at least one parallel branch B2. The series branch B1 is connected between the input end IN and the output end OUT, one end of the parallel branch B2 is connected to the series branch B1, and the other end of the parallel branch B2 is connected to a ground end, at least two series resonators (for example, Si, S₂..., Sₙ) connected in series are disposed in the series branch B1, and parallel resonators (for example, P₁, P₂..., Pₙ₋₁) are disposed in each parallel branch B2.

In some embodiments, at least one series resonator (for example, it may be all) in the foregoing series branch B1 may be set to use the resonator provided in any one of the foregoing possible implementations of this application.

In some embodiments, the parallel resonator in the at least one parallel branch B2 may be set to use the resonator provided in any one of the foregoing possible implementations of this application.

In some embodiments, the series resonator in the series branch B1 and the parallel resonator in the parallel branch B2 may be set to use the resonators provided in any one of the foregoing possible implementations of this application.

In addition, in some possible implementations, the foregoing SAW resonator and the DMS resonator may be used to form a filter. As shown in FIG. 14, the filter may include a plurality of DMS resonators (DMS₁, DMS₂..., DMSₙ) disposed in parallel, and the DMS resonators (DMS₁, DMS₂..., DMSₙ) disposed in parallel are disposed in series with the ladder filter.

Certainly, the foregoing is merely an example for description. In practice, the filter may be designed according to the resonator provided in embodiments of this application.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A resonator, comprising a piezoelectric substrate and an interdigital transducer disposed on the piezoelectric substrate, wherein
the interdigital transducer comprises:
a plurality of interdigital electrodes, wherein the plurality of interdigital electrodes comprise a first interdigital electrode and a second interdigital electrode that are alternately disposed in sequence, and a parallel disposition direction of the plurality of interdigital electrodes is a first direction;
a first bus bar and a second bus bar, wherein the first bus bar and the second bus bar are distributed on different sides of the plurality of interdigital electrodes in a direction perpendicular to the first direction, the first bus bar is connected to the first interdigital electrode, and the second bus bar is connected to the second interdigital electrode; and
a first piston suppression structure (piston), a second piston, a third piston, and a fourth piston, wherein
the first piston and the second piston are respectively disposed on two end surfaces of a side of the first interdigital electrode away from the piezoelectric substrate, and the third piston and the fourth piston are respectively disposed on two end surfaces of a side of the second interdigital electrode away from the piezoelectric substrate, wherein the first piston is close to the first bus bar relative to the second piston, the third piston is close to the first bus bar relative to the fourth piston, the first piston and the third piston have different lengths, and the second piston and the fourth piston have different lengths.

2. The resonator according to claim 1, wherein
a length of the first piston is less than a length of the third piston; and
a length of the fourth piston is less than a length of the second piston.

3. The resonator according to claim 1 or 2, wherein
the length of the first piston is the same as the length of the fourth piston; and
the length of the second piston is the same as the length of the third piston.

4. The resonator according to any one of claims 1 to 3, wherein
the first piston is flush with an edge of the third piston on a side close to the second bus bar; and
the second piston is flush with an edge of the fourth piston on a side close to the first bus bar.

5. The resonator according to any one of claims 1 to 4, wherein
the interdigital transducer further comprises a first dummy finger electrode and a second dummy finger electrode, wherein
the first dummy finger electrode is disposed between the first bus bar and the second interdigital electrode, and is connected to the first bus bar; and
the second dummy finger electrode is disposed between the second bus bar and the first interdigital electrode, and is connected to the second bus bar.

6. The resonator according to any one of claims 1 to 5, wherein
the resonator further comprises a reflective structure that is disposed on the piezoelectric substrate and that is respectively located on two sides of the interdigital transducer in the first direction, wherein
the reflective structure comprises a plurality of reflective electrodes disposed in parallel in the first direction, and a first reflective bus bar and a second reflective bus bar that are located on two sides of the plurality of reflective electrodes in the direction perpendicular to the first direction, the first reflective bus bar and the first bus bar are located on a same side, and the second reflective bus bar and the second bus bar are located on a same side; and
two ends of the plurality of reflective electrodes are respectively connected to the first reflective bus bar and the second reflective bus bar; or
the plurality of reflective electrodes comprise a first reflective electrode and a second reflective electrode that are alternately disposed in sequence, and a boundary reflective electrode located on an outermost side in a direction away from the interdigital transducer, wherein the first reflective electrode is connected to the first reflective bus bar, the second reflective electrode is connected to the second reflective bus bar, and two ends of the boundary reflective electrode are respectively connected to the first reflective bus bar and the second reflective bus bar.

7. The resonator according to claim 6, wherein
the reflective structure further comprises a first dummy finger reflective electrode and a second dummy finger reflective electrode, wherein
the first dummy finger reflective electrode is disposed between the first reflective bus bar and the second reflective electrode, and is connected to the first reflective bus bar; and
the second dummy finger reflective electrode is disposed between the second reflective bus bar and the first reflective electrode, and is connected to the second reflective bus bar.

8. The resonator according to claim 6 or 7, wherein
the reflective structure further comprises reflective pistons disposed on two end surfaces of the reflective electrode on a side away from the piezoelectric substrate, wherein
a reflective piston located on a surface of the reflective electrode and close to a side of the first reflective bus bar is disposed in a same manner as the first piston and the third piston; and
a reflective piston located on the surface of the reflective electrode and close to a side of the second reflective bus bar is disposed in a same manner as the second piston and the fourth piston.

9. The resonator according to any one of claims 1 to 8, wherein
the piezoelectric substrate comprises a support layer, a charge trapping layer, a sound speed control layer, and a piezoelectric layer that are sequentially disposed in a direction close to the interdigital transducer; or
the piezoelectric substrate comprises a single-layer piezoelectric wafer substrate.

10. The resonator according to any one of claims 1 to 9, wherein the resonator further comprises an insulating dielectric layer covering a surface of a side of the interdigital transducer away from the piezoelectric substrate.

11. The resonator according to any one of claims 1 to 10, wherein
the resonator comprises a plurality of interdigital transducers disposed in parallel in the first direction.

12. A filter, comprising the resonator according to any one of claims 1 to 11.

13. An electronic device, comprising a transceiver, a memory, and a processor, wherein the transceiver comprises the filter according to claim 12.
